# EUROPÄISCHE PATENTSCHRIFT

(11) **EP 1 111 747 B1**
(45) Veröffentlichungstag und Bekanntmachung des Hinweises auf die Patenterteilung: **13.02.2008**
(21) Anmeldenummer: 00127545.2
(22) Anmeldetag: 15.12.2000
(51) Int. Cl.: H02B 1/32, H02B 1/20, H05K 7/14

(54) **Geräteschrank**
Cabinet for apparatus
Armoire pour appareillage

(30) Priorität: 23.12.1999 DE 19962659
(43) Veröffentlichungstag der Anmeldung: 27.06.2001
(73) Patentinhaber: Knürr AG, 94424 Arnstorf (DE); Fujitsu Siemens Computers GmbH, 80807 München (DE)
(72) Erfinder: Bumeder, Gerhard, 84164 Moosthenning (DE); Müller, Peter, 85655 Grosshelfendorf (DE); Hering, Roland, 80939 München (DE); Kieneke, Rainer, 33104 Paderborn (DE); Lüthen, Bernhard, 33106 Paderborn (DE); Naber, Werner, 86157 Augsburg (DE)
(74) Vertreter: Heim, Hans-Karl

(56) Entgegenhaltungen:
- DE-A- 3 243 063
- DE-A- 4 125 618
- DE-U- 29 515 297
- DE-U- 29 806 284
- DE-U- 29 823 108
- DE-U- 29 909 806
- GB-A- 2 321 786

## Beschreibung

Die Erfindung betrifft einen Geräteschrank gemäß dem Oberbegriff des Anspruchs 1 sowie eine Einrichtung zur Kabelführung in einem Geräteschrank gemäß dem Oberbegriff des Anspruchs 23.

Die Erfindung ist insbesondere für Serverschränke vorgesehen, bei denen Server übereinander und ausziehbar in einem Einbauraum angeordnet sind.

Bei den bekannten Geräteschränken erfolgt die Verkabelung der Geräte an der Rückseite, und auch Einrichtungen zur Zuführung der Anschlusskabel der Geräte sind in der Regel in einem rückseitigen Bereich hinter dem Einbauraum angeordnet.

Bei einem aus dem deutschen Gebrauchsmuster 298 06 284.4 bekannten Geräteschrank sind Mehrfach-Kabelgelenkführungen vorgesehen, die jeweils über ein schrankseitiges Gelenk an einem rückseitigen Vertikalholm des Geräteschrankes und über ein geräteseitiges Gelenk am jeweiligen Gerät befestigt werden. Es sind wenigstens zwei Tragarmschenkel und ein Zwischengelenk vorgesehen. Bei herausgezogenem Gerät sind die Tragarmschenkel auseinandergespreizt, und bei eingeschobenem Gerät sind sie hinter dem Gerät zusammengeklappt, können jedoch unter Freigabe der Geräterückseite nach hinten weggeklappt werden. Zur Belüftung der Geräte sind die Tragarmschenkel und Zwischengelenkeinsätze mit Belüftungsöffnungen versehen.

Die horizontale Kabelführung im rückseitigen Bereich der Geräteschränke kann zu einer Behinderung der Zugänglichkeit der Geräte bei der Verkabelung und der Wartungsmöglichkeiten der Servereinschübe führen. Darüber hinaus wird wegen der immer tieferen Geräte, insbesondere der tieferen Server, die Kabelführung im rückseitigen Bereich weiter eingeschränkt.

Es ist außerdem bekannt (DE 298 23 108 U1), die Kabelversorgung der Geräte mit Hilfe eines Kabelbodens und einer integrierten Kabelkette durchzuführen. Der Kabelboden, der in der Regel am Boden des jeweiligen Einschubs befestigt wird, erfordert jedoch eine zusätzliche Höheneinheit und verringert somit den zur Verfügungung stehenden Einbauraum eines Geräteschrankes.

Aus der DE 41 25 618 A1 ist ein Schaltschrank mit einer Tür bekannt, über deren Gelenk eine Verdrahtung geführt wird. Zur Herstellung der Verdrahtung wird ein Drahtwickelgerät verwendet, mit welchem der zu verlegende Draht kontaktfest um Haltestifte herumgewickelt wird.

In der DE 295 15 297 U1 ist eine Vorrichtung für Teleskop-Saugrohre von Bodenstaubsaugern zum elektrischen Anschluss von kombinierbaren Zusatzgeräten über Kabelverbindungen beschrieben. Das Teleskop-Saugrohr ist mit einem Magazinrohr verbindbar und die Kabelverbindung im Magazinrohr ist flaschenzugartig angeordnet und über eine lose, federbeaufschlagte Rolle als Schlaufe beführt, wobei die Rolle in einem Endbereich des Magazinrohres über ein ausziehbares Ende geführt ist.

Aus der DE 299 09 806 U1 ist ein Trägerteil mit Wickelelementen bekannt, welche einer geordneten Unterbringung einer nicht benötigten Kabellänge dienen. Vor- und nachgeordnete Fixiermittel ermöglichen ein Halten und Fixieren eines Wickelanfangs und eines Wickelendes einer Leitung.

Ein Schrank oder ein Gerüst für die Aufnahme von Einschüben elektrischer Anlagen ist in der DE 32 43 063 C2 beschrieben. In einem rückseitigen Bereich des Schrankes sind Stromsammelschienen und vor diesen vormontierbare, den einzelnen Einschubetagen gesondert zugeordnete Trägerelemente angeordnet. In einer alternativen Anordnung können die Trägerelemente asymmetrische angeordnet sein und weisen an einem Endbereich Wandungselemente auf, welche einen Kabel- und Anschlussraum begrenzen. Der Kabel- und Anschlussraum dient der vertikalen Kabelführung. Eine horizontale Kabelführung erfolgt hinter dem Einschubbereich, woraus eine begrenzte Zugänglichkeit und eine relativ geringe Schranktiefe resultieren.

Aus GB 2 321 786 A ist ein Geräteschrank der Daten- und Netzwerktechnik mit einem Kabelmanagmentsystem bekannt, bei welchem in einem seitlichen Freiraum ein Kabelrahmen angeordnet ist. Der Kabelrahmen ist aus dem Freiraum herausziehbar und mit horizontalen Kabelträgern versehen, welche frontseitig Führungselemente zur vertikalen Kabelführung aufweisen.

Der Erfindung liegt die **Aufgabe** zugrunde, einen Geräteschrank zu schaffen, welcher bei einem vergrößerten Einbauraum kostengünstig herstellbar ist und eine optimierte Kabelführung ermöglicht. Außerdem soll eine besonders vorteilhafte Einrichtung zur Kabelführung in einem erfindungsgemäßen Geräteschrank geschaffen werden.

Erfindungsgemäß wird die Aufgabe durch die Merkmale des Anspruchs 1 und des Anspruchs 23 gelöst. Zweckmäßige und vorteilhafte Ausgestaltungen sind in den Unteransprüchen und in der Figurenbeschreibung enthalten.

Ein Grundgedanke der Erfindung kann darin gesehen werden, in einem durch eine asymmetrische Anordnung des Einbauraums gebildeten, seitlichen Freiraum, welcher rechts oder links neben dem Einbauraum angeordnet sein kann und zur vertikalen und horizontalen Kabelführung genutzt wird, indem Kabelträger entsprechend den im Einbauraum übereinander angeordneten Geräten im seitlichen Freiraum horizontal angeordnet sind, verschwenkbare Tragarme zur horizontalen Kabelführung anzuordnen und die Kabelführung zu den Rückseiten der Geräte in einer optimierten Anordnung zu gewährleisten.

Die Tragarme sind zweckmäßigerweise horizontal ausgerichtet, um eine vertikale Schwenkachse verstellbar und weisen eine Länge auf, welche etwa dem halben Verfahrweg der ausziehbaren Geräte entspricht.

Mit dem seitlichen Freiraum und den darin angeordneten verschwenkbaren Tragarmen als horizontale Kabelträger ist der Vorteil verbunden, dass der Bereich hinter dem Einbauraum im Wesentlichen frei von einer horizontalen Kabelführung ist, welche wie die vertikalen Kabelstränge in dem gewonnenen seitlichen Freiraum aufgenommen werden können. Die Zugänglichkeit der Rückseite der Geräte und deren Verkabelung ist damit nicht mehr durch eine horizontale Kabelführung behindert. Es bestehen bessere Wartungsmöglichkeiten der Geräte von hinten, und es können grundsätzlich tiefere Geräte, insbesondere tiefere Server, bei gleicher Schranktiefe aufgenommen werden.

Es ist von besonderem Vorteil, dass der erfindungsgemäße Geräteschrank auf Bauteile der bisher bekannten Geräteschränke, d.h. auf ein Grundstell, daran befestigte Verkleidungsteile und vertikale Profile, welche den Einbauraum begrenzen, zurückgreifen kann, wobei bevorzugt die Breite des Geräteschrankes variiert und beispielsweise bei einem 19"-Rack von 600 mm auf 700 mm vergrößert werden kann.

Die asymmetrische Anordnung des Einbauraums kann in einer besonders einfachen, kostengünstigen Weise dadurch erreicht werden, dass drei der vertikalen Profile des Einbauraums, d.h., ein frontseitiges Profil und die zwei rückseitigen Profile, nach außen in Richtung Grundgestell versetzt und z.B. direkt oder auch indirekt am Grundgestell befestigt und das zweite frontseitige Profil zur Ausbildung des seitlichen Freiraums nach innen in Richtung Einbauraum versetzt angeordnet werden.

Ein Vorteil der verschwenkbaren Tragarme zur seitlichen horizontalen Kabelführung und/oder der vertikalen Kabelführung bzw. Kabelversorgung zu 19"- oder auch 24"-Einschüben besteht darin, dass eine optimale Zuführung aus einem Kabelstamm möglich und insbesondere keine zusätzliche Höheneinheit für einen Kabelboden erforderlich ist. Es wird eine raumsparende, aufgeräumte und servicefreundliche Lösung für viele Anwendungen in 19"- oder 24"-Geräteschrank gewährleistet, wobei dies auch beim Ausziehen der Einschübe gesichert ist.

Es ist besonders vorteilhaft, einen Geräteschrank mit einer Breite von 700 mm mit einem 19"-Einbauraum zu versehen, welcher asymmetrisch angeordnet ist. Der Geräteschrank kann beispielsweise eine Tiefe von 900 mm und eine Höhe von 1970 mm haben. Der links oder rechts neben dem Einbauraum gebildete, seitliche Freiraum wird für die Kabelführung bzw. das Kabelmanagement ausgebildet. Besonders vorteilhaft ist, dass ein zusätzlicher, insbesondere frontseitiger Bereich des seitlichen Freiraums zum Einbau von Geräten mit entsprechenden Abmessungen, insbesondere einer geeigneten Tiefe, genutzt werden kann. Hinter diesem zusätzlichen Einbauraum werden Einrichtungen für eine horizontale Kabelführung und vorteilhafterweise auch für eine vertikale Kabelführung über beispielsweise einen Kabelstamm angeordnet. Bei den vorgenannten beispielhaften Schrankabmessungen können in dem zusätzlichen Einbauraum z.B. drei Einschübe von jeweils zwei Höheneinheiten, welche jedoch hochkant übereinander angeordnet werden und eine relativ geringe Tiefe aufweisen, untergebracht werden.

Grundsätzlich besteht jedoch die Möglichkeit, den seitlichen Freiraum ausschließlich zur Kabelführung zu verwenden und beispielsweise entsprechend den übereinander angeordneten Geräten im Einbauraum horizontal angeordnete Kabelträger vorzusehen, welche als verschwenkbare Tragarme ausgebildet sind. Die Kabelträger können dann von einem rückseitigen Vertikal- bzw. 19"-Profil bis zu dem nach innen versetzt angeordneten, frontseitigen Vertikalprofil und einem frontseitigen Vertikalholm des Geräteschrankes reichen.

Die Kabelträger können auch als Tragplatten ausgebildet und mit Umlenk- oder Führungselementen versehen sein. Diese sind derart angeordnet, dass eine Kabelumlenkung etwa in der Mitte des Verfahrweges der ausziehbaren Geräte ohne eine Zugbelastung und ohne Abknickung gewährleistet ist. Indem die Kabelführung oder das Kabelmanagement die Kabel auf etwa 50 % des Verfahrweges fixiert, kann die freie Kabellänge minimiert werden. Neben diesem material- und kostenmäßigen Vorteil können außerdem definierte Biegeradien durch Anordnung von Führungs- und Umlenkelemente erreicht werden. Als Führungs- und Umlenkelemente können Gelenke und Umlenkrollen sowie verschwenkbare Tragarme, Schlepp- oder Kabelführungsketten oder auch Flexrohre angeordnet werden.

Es ist zweckmäßig, die Tragplatten mit einem Lochraster zu versehen, damit die Lage der Führungs- und Umlenkelemente variiert und insbesondere an den Verfahrweg der Geräte angepasst werden kann. An den Geräten und Servern können Zugentlastungen für die Daten- und Netzleitungen vorgesehen werden.

Die verschwenkbaren Tragarme können auch als eine Kabelführungskette ausgebildet sein, welche aus einer Vielzahl von gegeneinander verschwenkbaren Kettengliedern besteht. Die Kabelführungskette, welche auch als Schleppkette bezeichnet werden kann, kann um eine vertikale Schwenkachse an der Tragplatte oder auch einem anderen Teil des Geräteschrankes und mit dem anderen Ende an dem 19"- oder 24"-Einschub befestigt sein. Mit Hilfe der Kabelführungskette werden die Anschlussleitungen in einem definierten Biegeradius geführt, so dass eine geordnete und sichere Verkabelung gewährleistet ist. Es ist ein freier Zugang zu den Komponenten des Einschubs, beispielsweise zur Stromversorgung oder zu den Boards, möglich. Durch den vorgegebenen Biegeradius der Kabelführungskette werden auch Lichtwellenleiter (LWL) definiert abgebogen und geführt. Ein Knicken der LWL-Leitungen ist ausgeschlossen.

Es kann sich als vorteilhaft erweisen, an den plattenartigen Kabelträgern mit Führungs- und Umlenkelementen einen Tragarm, z.B. eine Kabelführungskette oder auch eine Kabelbrücke mit einem beweglichen Kopfteil, verschwenkbar zu befestigen. Die Schwenkachsen der alternativ ausgebildeten Tragarme am Kabelträger befinden sich sinnvollerweise im Bereich des halben Verfahrweges der ausziehbaren Geräte.

Eine Kabelbrücke mit beweglichem Kopfteil ist nicht nur für ein seitliches Kabelmanagement, sondern für alle horizontale Kabelführungen vorteilhaft. Die Kabelbrücke ist prinzipiell U-förmig oder auch C-förmig ausgebildet, so dass die Kabel von oben eingelegt werden können. Die Kabelbrücke weist einen starren Bereich und einen beweglichen Bereich auf, welcher aus definiert ausgebildeten Gliederelementen besteht. Beispielsweise kann der starre Bereich aus Metall und die Gliederelemente aus einem Kunststoff gefertigt sein.

Der bewegliche Bereich ist an einem Ende des starren Bereichs insbesondere verschwenkbar angeordnet und mit seinem freien Ende am Einschub zu befestigen. Grundsätzlich kann der bewegliche Bereich auch rackseitig angeordnet werden.

Eine weitere alternative Möglichkeit besteht darin, den beweglichen Bereich zwischen zwei starren Bereichen verschwenkbar zu befestigen oder einen starren Bereich mit zwei beweglichen Bereichen, welche an beiden Enden des starren Bereichs angeordnet sind, zu versehen.

Es ist besonders vorteilhaft, die Gliederelemente des beweglichen Bereichs derart auszubilden, dass ein Ausschwenken nur in eine Richtung, d.h. nach rechts oder links, möglich ist. Außerdem ist es zweckmäßig, einen maximalen Biegeradius, insbesondere für LWL-Kabel, durch die Gliederelemente vorzugeben. Der Biegeradius und/oder das Ausschwenken in eine Richtung können bei der erfindungsgemäßen Kabelbrücke durch eine polygonale, z.B. achteckige Grundfläche der Gliederelemente und trapezförmige vertikale Schenkel an zwei einander gegenüberliegenden Kanten vorgegeben werden. Durch eine unterschiedliche Kantenlänge der Grundfläche können die einander gegenüberliegenden trapezförmigen Schenkel unterschiedlich breit ausgebildet werden, wodurch ein maximaler Biegeradius und/oder ein Verschwenken in eine oder beide Richtungen vorgebbar sind. Die Höhe der trapezförmigen Schenkel entspricht der Schenkelhöhe des Festteils. In der Regel werden etwa drei bis vier Gliederelemente einen beweglichen Bereich der erfindungsgemäßen Kabelbrücke bilden.

Ein weiterer Vorteil des erfindungsgemäßen Geräteschrankes besteht darin, dass die Geräte bzw. Server an an sich bekannten Auszugselementen, z.B. Teleskopschienen, ausziehbar bzw. einschubartig angeordnet werden können. Die Teleskopschienen werden an den nach außen in Richtung Grundgestell bzw. nach innen in Richtung Einbauraum versetzten Vertikal- bzw. 19"Profilen befestigt, wobei die rückseitigen Bereiche der an den seitlichen Freiraum angrenzenden Teleskopschienen an rückseitigen Halteeinrichtungen, z.B. U- oder L-förmigen Winkeln befestigt werden können. Die rückseitigen Halteeinrichtungen können zweckmäßigerweise am Grundgestell befestigt werden und gleichzeitig zur Befestigung der Kabelträger, insbesondere der Tragplatten, dienen.

Wenn ein frontseitiger Bereich des seitlichen Freiraums als zusätzlicher Einbauraum für Einschübe genutzt wird, ist es vorteilhaft, eine frontseitige Vertikalstütze anzuordnen. Die frontseitige Vertikalstütze kann zur Aufnahme wenigstens einer Einschubschiene des zusätzlichen Einbauraums und gleichzeitig zur Befestigung der horizontalen Kabelträger dienen. Wenn die rückseitigen Halteeinrichtungen zur Überbrückung des Abstandes zwischen dem Grundgestell bzw. dem rückseitigen Vertikalholm und den Teleskopschienen der ausziehbaren Geräte bzw. Server als U- oder L-förmige Winkelprofile ausgebildet sind, besteht die besonders vorteilhafte Möglichkeit, die Winkelprofile zur vertikalen Kabelführung und/oder zur Befestigung von Kabelhaltern zu nutzen.

In Abhängigkeit von der Ausbildung des seitlichen Freiraums zur Anordnung des Kabelmanagements bzw. der horizontalen Kabelführungseinrichtungen kann eine Geräteschranktür links- oder rechtsanschlagend angeordnet werden.

Die Erfindung wird nachstehend anhand einer Zeichnung weiter erläutert; in dieser zeigen in einer stark schematisierten Darstellung
- Fig. 1: einen Querschnitt eines erfindungsgemäßen Geräteschrankes mit einem Gerät in eingeschobener Betriebsstellung;
- Fig. 2: einen Querschnitt des erfindungsgemäßen Geräteschrankes nach Fig. 1, jedoch mit herausgezogenem Gerät;
- Fig. 3: eine frontseitige Ansicht des Geräteschrankes nach Fig. 1, jedoch ohne Fronttür;
- Fig. 4: eine rückseitige Ansicht des Geräteschrankes nach Fig. 1 und 3, jedoch ohne Rückwand;
- Fig. 5: einen Querschnitt eines alternativ ausgebildeten erfindungsgemäßen Geräteschrankes;
- Fig. 6: eine ausschnittsweise perspektivische Darstellung eines erfindungsgemäßen Geräteschrankes im Bereich der seitlichen Kabelführung;
- Fig. 7: eine ausschnittsweise perspektivische Darstellung eines erfindungsgemäßen Geräteschrankes im Bereich einer unteren seitlichen Kabelführung mit herausgezogenem Gerät;
- Fig. 8: eine ausschnittsweise perspektivische Darstellung eines erfindungsgemäßen Geräteschrankes im Bereich zweier seitlicher Kabelführungen mit herausgezogenem Gerät;
- Fig. 9: eine ausschnittsweise perspektivische Darstellung einer erfindungsgemäßen Kabelführung mit einer Kabelführungskette;
- Fig. 10: eine perspektivische Darstellung einer Kabelbrücke mit beweglichem Teil und
- Fig. 11: eine Draufsicht auf eine Kabelbrücke nach Fig. 10.

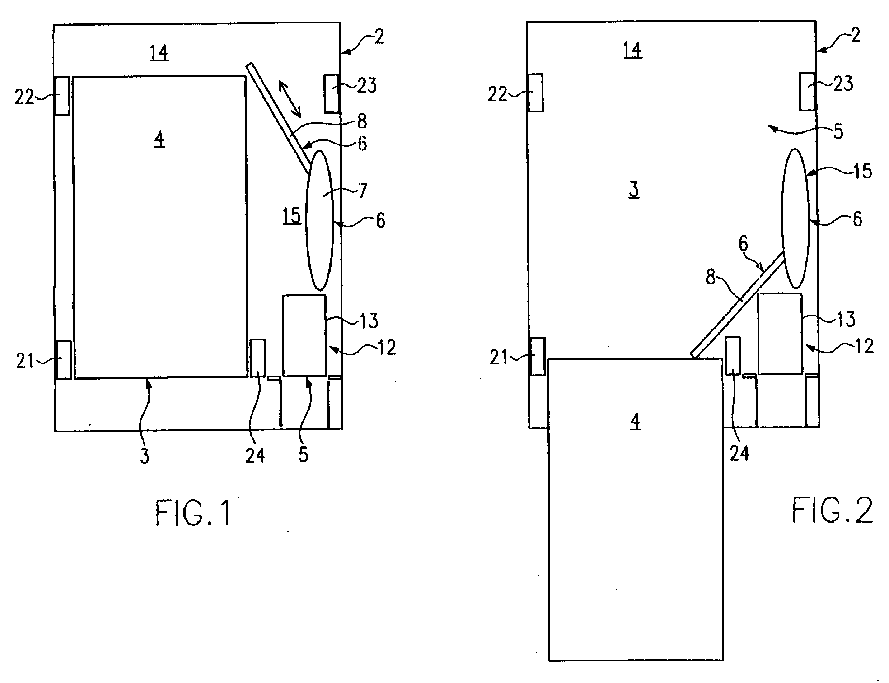

In den Fig. 1 bis 4 ist als Geräteschrank 2 ein Serverschrank mit einem Einbauraum 3 für übereinander angeordnete Server als Geräte 4 in einer stark schematisierten Darstellung gezeigt. In allen Figuren sind gleiche Merkmale mit identischen Bezugszeichen versehen.

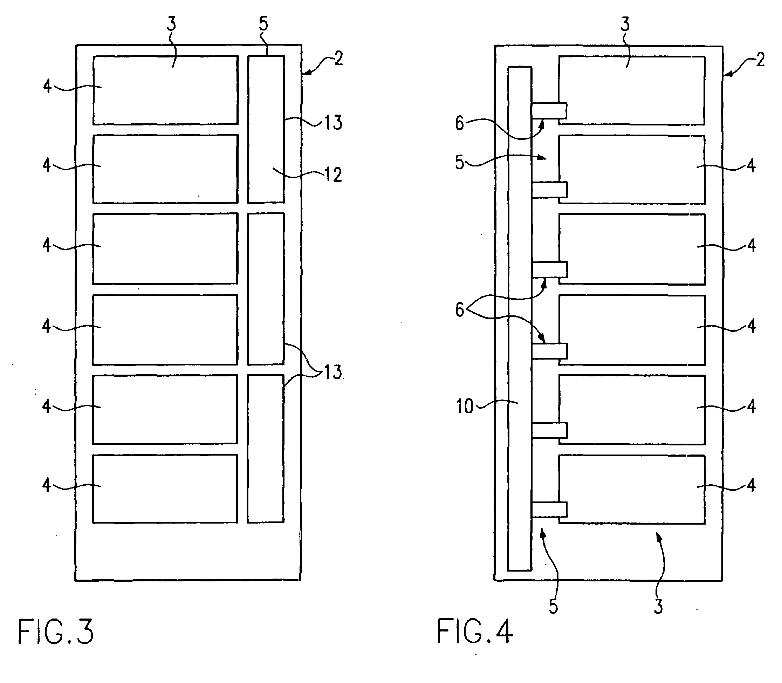

Der Einbauraum 3 ist asymmetrisch, in diesem Ausführungsbeispiel nach links versetzt, angeordnet, wodurch rechts neben dem Einbauram 3 ein seitlicher Freiraum 5 gebildet wird. Der seitliche Freiraum 5 ist in einem Frontbereich als ein zusätzlicher Einbauraum 12 ausgebildet, welcher in diesem Beispiel zur Anordnung von drei 19"-Einschüben 13 ausgebildet, welche hochkant angeordnet werden (siehe auch Fig. 3). Hinter den Einschüben 13 sind in einem Mittenbereich 15 Kabelträger 6 zur horizontalen Führung der Kabel (nicht dargestellt) komplementär zu den übereinander angeordneten Geräten 4 angeordnet.

Bei der in den Fig. 1 und 2 gezeigten Kabelführungsvariante erfolgt auch die vertikale Kabelführung in dem Mittenbereich 15. Die horizontale Kabelführung wird über verschwenkbare Tragarme 8 realisiert, welche eine Länge aufweisen, die etwa dem halben Verfahrweg des ausziehbaren Gerätes 4 entspricht. Es ist offensichtlich, dass mit den im seitlichen Freiraum 5 angeordneten Einrichtungen 6, 8 für das Kabelmanagement die Vorteile einer auf etwa die Hälfte verkürzten Länge der Kabel und deren geordnete und unversehrte Führung erreicht werden.

Ein rückseitiger Bereich 14 hinter dem Einbauraum 3 wird von der horizontalen Kabelführung im Wesentlichen freigehalten und dient der Verkabelung der Geräte 4 untereinander und der Einführung der Kabel (nicht dargestellt) aus dem seitlichen Freiraum 5. Aus den Fig. 1 und 2 geht hervor, dass der rückseitige Bereich 14 grundsätzlich für tiefere Geräte 4, beispielsweise Server, genutzt werden kann.

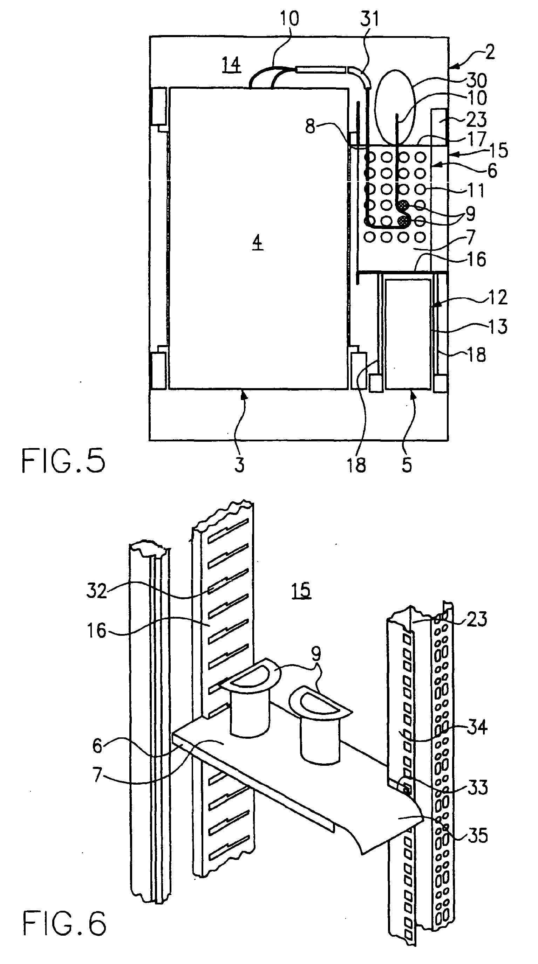

Die asymmetrische Anordnung des Einbauraums 3 für die übereinander angeordneten Geräte 4 wird dadurch erreicht, dass rückseitige Vertikalprofile 22, 23 und ein frontseitiges Vertikalprofil 21 nach außen in Richtung Grundgestell versetzt und am Grundgestell, beispielsweise an einem oberen und unteren Rahmen (nicht dargestellt), des Geräteschrankes 2 befestigt werden. Ein frontseitiges Vertikalprofil 24 ist zur Ausbildung des seitlichen Freiraums 5 nach innen in Richtung Einbauraum versetzt. Zur Erhöhung der Stabilität können Multifunktionsstreben (nicht dargestellt) vorgesehen werden. Befestigung und Anordnung der Kabelträger 6 sowie von Auszugselementen für die Geräte 4 und Einschübe 13 werden im Zusammenhang mit der Fig. 5 und in den weiteren Figuren erläutert.

Fig. 3 und 4 verdeutlichen die Vergrößerung des gesamten Einbauraums 3 durch die Schaffung eines seitlichen Freiraums 5 aufgrund der asymmetrischen Anordnung des Einbauraums 3 für die Geräte bzw. Server 4. Der Geräteschrank 2 weist in diesem Ausführungsbeispiel eine Breite von 700 mm sowie eine Tiefe von 900 mm und eine Höhe von 1800 mm (38 Höheneinheiten) auf. In den 19"-Einbauraum 3 sind gemäß den Figuren 3 und 4 sechs Server bzw. Geräte 4 und in einem zusätzlichen Einbauraum 12, welcher in einem frontseitigen Bereich des seitlichen Freiraums 5 ausgebildet ist, drei hochkant angeordnete 19"-Einschübe 13 von jeweils zwei Höheneinheiten angeordnet.

Die in Fig. 4 gezeigte rückseitige Ansicht des Geräteschrankes 2 ohne Rückwand verdeutlicht die vertikale Führung der Kabel 10 und die etwa in Höhe der Geräte 4 angeordneten Kabelträger 6 für die horizontale Führung der Kabel 10 in dem seitlichen Freiraum 5.

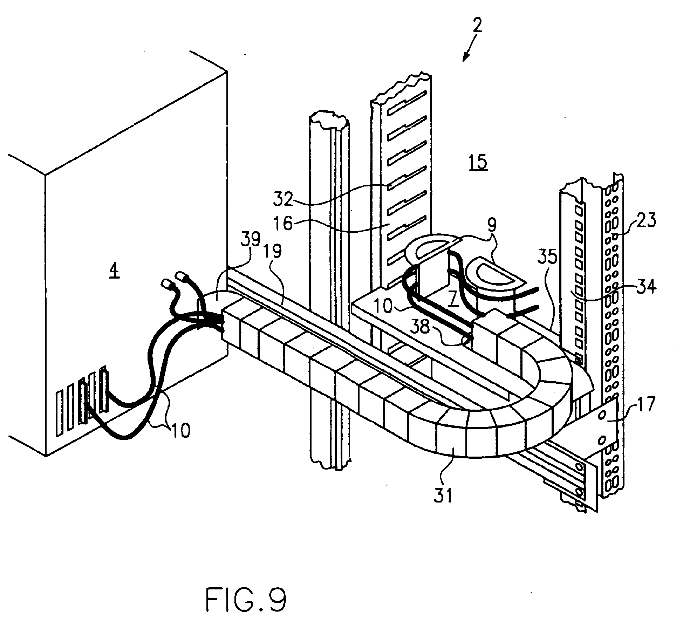

Bei dem in Fig. 5 dargestellten Ausführungsbeispiel eines Geräteschrankes 2 befindet sich eine Anordnung zur horizontalen Kabelführung ebenfalls in einem Mittenbereich 15 des seitlichen Freiraums 5. Zur horizontalen Führung sind als Kabelträger 6 Tragplatten 7 angeordnet, welche mit einem Lochraster 11 versehen sind. Das Lochraster 11 dient zur Aufnahme von Führungs- und/oder Umlenkelementen 9, welche dadurch verstellt und dem Verfahrweg der ausziehbaren Geräte 4 angepasst werden können. Kabel 10 werden in abstandsweise befestigten Kabelhaltern 30 vertikal und im Bereich der Tragplatten 7 horizontal geführt, an den Führungs- und Umlenkelementen 9 umgelenkt und an einem Tragarm 8, welcher als eine 90° abgebogene Schlepp- oder Kabelführungskette 31 (siehe auch Fig. 9) ausgebildet ist zu einem rückseitigen Bereich 14 und zu den Geräten 4 geordnet, sicher und knickfrei geführt.

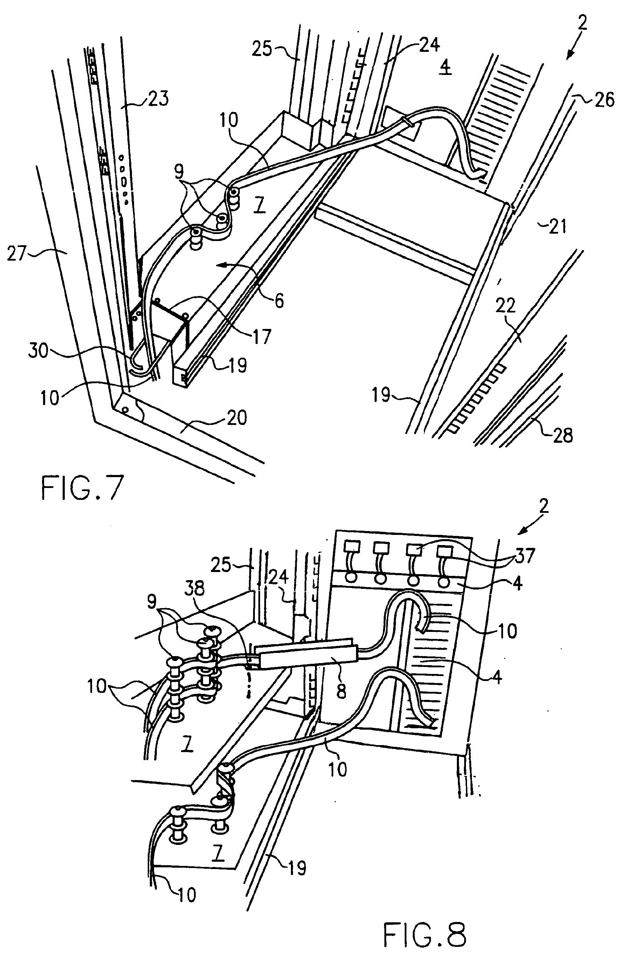

Die Tragplatte 7 ist an einer frontseitigen Vertikalstütze 16 und indirekt über rückseitige Halteeinrichtungen 17 am rückseitigen Vertikalprofil 23 befestigt. Als rückseitige Halteeinrichtungen 17 sind in diesem Ausführungsbeispiel U-förmige Winkel angeordnet, an denen gleichzeitig Kabelhalter 30 für die vertikale Führung der Kabel 10 befestigt sind. Die rückseitigen Halteeinrichtungen 17 sind mit einem innenseitigen Schenkel an dem nach außen versetzten, rückseitigen Vertikalprofil 23 befestigt und dienen mit einem innenseitigen, parallelen Schenkel zur Befestigung von Auszugselementen 19, insbesondere von Teleskopschienen, (siehe Fig. 7) für die Geräte 4. Die Einschübe 13 in dem frontseitigen Einbauraum 12 sind an Einschubschienen 18 gehalten, welche an der frontseitigen Vertikalstütze 16 befestigt werden können. Alternativ können die Einschübe 13 auch über eine Frontbefestigung gehalten werden.

In der ausschnittsweisen Darstellung eines Geräteschrankes 2 nach Fig. 6 ist eine Vertikalstütze 16 gezeigt. Zur lösbaren und werkzeuglosen Aufnahme von Tragplatten 7 als Kabelträger 6 sind Schlitze 32 rasterartig ausgebildet, in welche die Tragplatten 7 mit einem komplementär ausgebildeten Befestigungselement (nicht dargestellt) eingreifen und vorzugsweise verrasten. Die in Fig. 6 gezeigte Tragplatte 7 ist als ein abgekantetes Blech mit wenigstens einem Befestigungsflansch 33 zur Schraubbefestigung an dem rückseitigen und mit einem Lochraster 34 versehenen Vertikalprofil 23 sowie mit einer Abbiegung 35, auf welcher die Kabel (nicht dargestellt) in vertikaler Richtung geführt werden, versehen. Zur Umlenkung der Kabel auf der Tragplatte 7 sind etwa halbkreisförmige Führungs- und Umlenkelemente 9 auf nicht dargestellten Befestigungselementen der Tragplatte 7 aufgesteckt. Die beispielsweise noppen- oder stabartigen Befestigungselemente sind derart angeordnet, dass die Umlenkelemente 9, welche z.B. aus einem Kunststoffmaterial gefertigt sind, wahlweise und verstellbar aufgesteckt werden können.

Bei dem in Fig. 7 ausschnittsweise dargestellten Geräteschrank 2 wurde der seitliche Freiraum 5 nicht mit einem zusätzlichen frontseitigen Einbauraum versehen, sondern nahezu vollständig zur horizontalen Kabelführung mit Hilfe eines Kabelträgers 6 in Form einer Tragplatte 7 ausgebildet. Die Tragplatte 7 ist ein etwa Z-förmig ausgebildetes Blech und mit drei Umlenkrollen 9 mit mehreren Rollensegmenten für übereinander geführte Kabel 10 versehen. Der horizontale Kabelträger 6 reicht von dem nach innen versetzten, frontseitigen Vertikalprofil 24 und einem frontseitigen Vertikalholm 25 bis zu dem nach außen versetzten, rückseitigen Vertikalprofil 23. Ein Server 4 ist in herausgezogener Stellung gezeigt. Als Auszugselemente 19 sind rechts wie üblich Teleskopschienen an den Vertikalprofilen 21, 23 und links an dem frontseitigen Vertikalprofil 24 befestigt. Rückseitig ist das an den seitlichen Freiraum 5 angrenzende Auszugselement 19 an einer zusätzlichen rückseitigen Halteeinrichtung 17, welche als ein U-förmiger und nach hinten offener Winkel ausgebildet ist, befestigt. An dieser U-förmigen Halteeinrichtung 17 ist ein Kabelhalter 30 zur vertikalen Kabelführung befestigt. Aus Fig. 7 geht das Grundgestell 20 mit einem unteren Rahmen sowie den rückseitigen Vertikalholmen 27, 28 ausschnittsweise hervor.

Der in Fig. 8 gezeigte Ausschnitt eines Geräteschrankes 2 zeigt ebenfalls ein nach vorn herausgezogenes Gerät 4 sowie Verkabelungen 37 an dessen Rückseite. Um eine geordnete, sichere und knickfreie horizontale Kabelzuführung zu gewährleisten, sind zwei Tragplatten 7 übereinander angeordnet. Die untere Tragplatte 7 weist drei Umlenk- bzw. Führungsrollen 9 für Kabel 10 auf, welche im Bereich der Rückseite des Gerätes 4 noch eine Zugentlastung (nicht dargestellt) aufweisen. Die obere Tragplatte 7 ist ebenfalls mit Umlenkrollen 9 versehen und weist außerdem einen verschwenkbaren Tragarm 8 auf. Der verschwenkbare Tragarm 8 ist als eine nach oben offene U-förmige Schiene mit einer vertikalen Schwenkachse 38 ausgebildet. Die Länge des Tragarms 8 und die Anordnung der vertikalen Schwenkachse 38 sind dem Verfahrweg des ausziehbaren Gerätes 4 angepasst, wobei die Länge etwa die Hälfte des Verfahrweges beträgt.

Fig. 9 zeigt einen Ausschnitt eines erfindungsgemäßen Geräteschrankes 2 mit einem Geräteeinschub 4, in diesem Fall einem Server, in herausgezogener Stellung. Von dem für den Server 4 vorgesehenen seitlichen Kabelmanagement sind in Fig. 9 eine Tragplatte 7, welche an einer frontseitigen Vertikalstütze 16 und an einem rückseitigen, nach außen versetzten Vertikalprofil 23 befestigt ist, sowie ein Auszugselement 19 gezeigt, welches an einer L-förmig ausgebildeten rückseitigen Halteeinrichtung 17 sowie an einem nicht dargestellten frontseitigen Vertikalprofil 21 befestigt ist. Fig. 9 verdeutlicht, dass der Zugang zur Stromversorgung und zu allen Steckern frei ist und auch die Luftströmung im Geräteschrank durch die Kabel 10 nicht behindert wird. Ein definierter Radius für die zum Server 4 geführten Kabel 10, insbesondere für LWL-Leitungen, ist durch eine Schleppbzw. Kabelführungskette 31 gewährleistet. Diese Kabelführungskette 31 weist eine entsprechende Anzahl von Kettengliedern auf, die derart schwenkbar miteinander verbunden sind, dass ein vorgebbarer Biegeradius gewährleistet ist. Rackseitig ist die Kabelführungskette 31 über eine vertikale Achse 38 verschwenkbar an der Tragplatte 7 und geräteseitig über eine Halterung 39 an dem Server 4 befestigt.

Durch die Kabelführungskette 31, welche im Geräteschrank 2 bzw. rackseitig und auf der Rückseite des Geräteeinschubs 4 angebracht wird, ist eine geordnete, geschützte und knickfreie Kabelführung beim Ausziehen und Einschieben des Geräteeinschubs 4 gewährleistet.

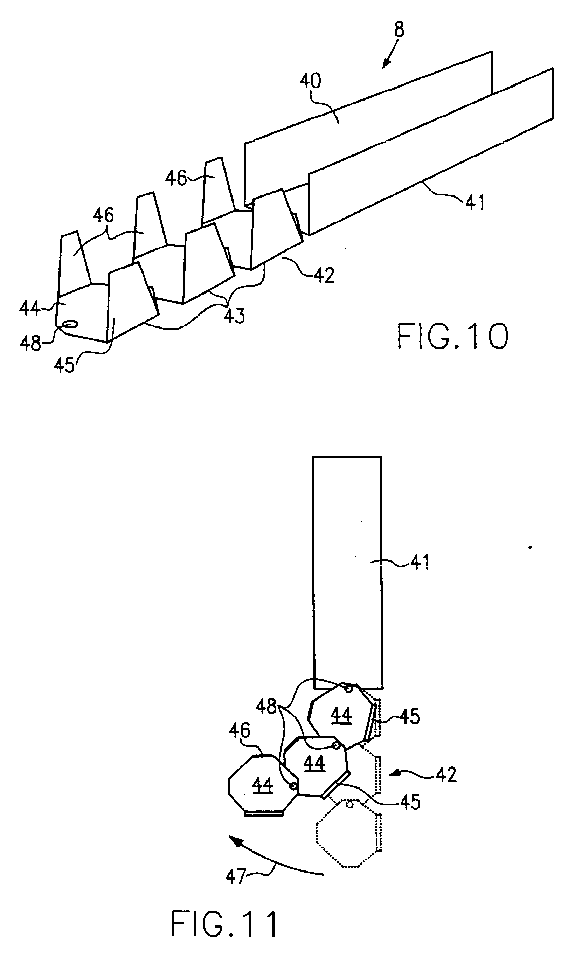

Fig. 10 und 11 zeigen eine weitere Ausbildungsvariante eines Tragarms 8 zur horizontalen Kabelführung. Der Tragarm 8 ist als eine Kabelbrücke 40 mit einem starren Bereich 41 und einem beweglichen Bereich 42 ausgebildet. Der starre Bereich 41 besteht aus Metall, und der bewegliche Bereich 42 umfasst Gliederelemente 43, welche aus Kunststoff gefertigt sind. Die Gliederelemente 43 sind derart ausgebildet, dass ein vorgebbares Ausschwenken nach einer Seite und/oder ein vorgebbarer Radius erreicht werden. Sowohl der starre Bereich 41 als auch der bewegliche Bereich 42 mit den gezeigten drei Gliederelementen 43 ist U-förmig ausgebildet. Die Gliederelemente 43 weisen jeweils eine Grundfläche 44, welche polygonal, in diesem Ausführungsbeispiel achteckig, ausgebildet ist, sowie zwei parallele Schenkel 45, 46 auf, welche trapezförmig ausgebildet sind, jedoch eine unterschiedliche Breite aufweisen. Die Höhe der trapezförmigen Schenkel 45, 46 entspricht der Höhe der Schenkel des Festteils 41. Kabel (nicht dargestellt) können von oben eingelegt und knickfrei geführt geführt werden, da die vorgebbare Breite der trapezförmigen Schenkel 45, 46 nur einen bestimmten Biegeradius zulassen.

Bei der in den Figuren 10 und 11 gezeigten Kabelbrücke 40 ist ein Ausschwenken nach links gemäß Pfeil 47 in Fig. 11 vorgesehen. Die breiteren Schenkel 45 verhindern einen Rechtsausschlag des beweglichen Teils 42 um die vertikalen Schwenkachsen 48, welche im Bereich der Grundflächen 44 angeordnet sind. Durch die Breite der schmaleren Schenkel 46, welche in diesem Ausführungsbeispiel links angeordnet sind, kann auch der maximale Abbiegeradius nach links begrenzt werden, so dass eine knickfreie Kabelführung, insbesondere von LWL-Leitungen, gewährleistet ist. Es können auch andere Begrenzungselemente vorgesehen und z.B. an den Grundflächen 44 der Gliederelemente 43 angeordnet sein.

Die erfindungsgemäße Kabelbrücke mit wenigstens einem beweglichen Teil ist außerordentlich kostengünstig durch einen Stanz- und Biegeprozeß herstellbar und einfach und rasch zu montieren.

## Patentansprüche

1. Geräteschrank
mit einem Einbauraum (3) für einschubartig angeordnete elektrische und elektronische Geräte (4), insbesondere Server, und mit einem Bereich (14) zur Verkabelung der Geräte (4), wobei der Einbauraum (3) unter Ausbildung eines seitlichen Freiraums (5) asymmetrisch angeordnet und der seitliche Freiraum (5) zur Kabelführung ausgebildet ist, in welchem zur horizontalen Führung von Kabeln (10) zu dem Bereich (14) und zu den Geräten (4) Kabelträger (6) entsprechend den übereinander angeordneten Geräten (4) horizontal angeordnet sind,
**dadurch gekennzeichnet,**
**dass** als Kabelträger (6) Tragarme (8) verschwenkbar in dem seitlichen Freiraum (5) angeordnet sind.

2. Geräteschrank nach Anspruch 1,
**dadurch gekennzeichnet,**
**dass** die Tragarme (8) eine Länge aufweisen, welche etwa dem halben Verfahrweg der einschubartig angeordneten Geräte (4) entspricht.

3. Geräteschrank nach Anspruch 1 oder 2,
**dadurch gekennzeichnet,**
**dass** als Kabelträger (6) Tragplatten (7) in dem seitlichen Freiraum (5) angeordnet sind und jeweils ein Tragarm (8) an einer Tragplatte (7) befestigt ist.

4. Geräteschrank nach Anspruch 3,
**dadurch gekennzeichnet,**
**dass** die Tragplatten (7) Führungs- und/oder Umlenkelemente (9) für die Kabel (10) aufweisen.

5. Geräteschrank nach Anspruch 4,
**dadurch gekennzeichnet,**
**dass** als Führungs- und Umlenkelemente (9) Gelenke und Umlenkrollen angeordnet sind.

6. Geräteschrank nach einem der Ansprüche 3 bis 5,
**dadurch gekennzeichnet,**
**dass** die Tragplatten (7) mit einem Lochraster (11) zur verstellbaren Aufnahme der Führungs- und Umlenkelemente (9) und/oder der Tragarme (8) versehen sind.

7. Geräteschrank nach einem der vorhergehenden Ansprüche,
**dadurch gekennzeichnet,**
**dass** der seitliche Freiraum (5) in einem frontseitigen Bereich als zusätzlicher Einbauraum (12) für Geräte (13) mit entsprechenden Abmessungen ausgebildet ist.

8. Geräteschrank nach Anspruch 7,
**dadurch gekennzeichnet,**
**dass** bei einer Schrankbreite von 700 mm und einer Schrankhöhe von 48 Höheneinheiten sowie einem Einbauraum (3), welcher dem 19"-System entspricht, der seitlich und frontseitig ausgebildete, zusätzliche Einbauraum (12) zur Aufnahme von drei vertikal angeordneten 19"-Einschüben (13) von jeweils drei Höheneinheiten und entsprechender Tiefe vorgesehen ist.

9. Geräteschrank nach einem der vorhergehenden Ansprüche,
**dadurch gekennzeichnet,**
**dass** die Kabelträger (6) wenigstens in einem Mittenbereich (15) des seitlichen Freiraums (5) angeordnet und an wenigstens einer frontseitigen Vertikalstütze (16) und einem rückseitigen, nach außen in Richtung Grundgestell versetzten Vertikalprofil (23) befestigt sind.

10. Geräteschrank nach Anspruch 9,
**dadurch gekennzeichnet,**
**dass** die frontseitige Vertikalstütze (16) zur Befestigung von Einschubschienen (18), welche in dem zusätzlichen Einbauraum (12) zur Aufnahme der 19"-Einschübe (13) angeordnet sind, ausgebildet ist.

11. Geräteschrank nach Anspruch 9 oder 10,
**dadurch gekennzeichnet,**
**dass** rückseitige Halteeinrichtungen (17) zur Befestigung von Auszugselementen (19) für die Geräte (4) des Einbauraums (3) vorgesehen und an dem rückseitigen, nach außen in Richtung Grundgestell versetzten Vertikalprofil (23) befestigt sind.

12. Geräteschrank nach Anspruch 11,
**dadurch gekennzeichnet,**
**dass** die rückseitigen Halteeinrichtungen (17) als im Querschnitt U- oder L-förmige Winkel ausgebildet sind.

13. Geräteschrank nach einem der Ansprüche 9 bis 12,
**dadurch gekennzeichnet,**
**dass** die frontseitige Vertikalstütze (16) zur lösbaren und/oder werkzeuglosen Aufnahme der Tragplatten (7) ausgebildet ist.

14. Geräteschrank nach einem der vorhergehenden Ansprüche,
**dadurch gekennzeichnet,**
**dass** der seitliche Freiraum (5) zur Kabelführung rechts oder links neben dem Einbauraum (3) angeordnet ist.

15. Geräteschrank nach einem der vorhergehenden Ansprüche,
**dadurch gekennzeichnet,**
**dass** zur asymmetrischen Anordnung des Einbauraums (3) ein frontseitiges Profil (21) und die zwei rückseitigen Profile (22, 23) nach außen in Richtung Grundgestell und das zweite frontseitige Profil (24) zur Ausbildung des seitlichen Freiraums (5) nach innen in Richtung Einbauraum (3) versetzt angeordnet sind.

16. Geräteschrank nach Anspruch 15,
**dadurch gekennzeichnet,**
**dass** das Grundgestell (20) einen rechteckigen oder X-förmigen oberen und unteren Rahmen und frontseitige Vertikalholme (25, 26) und rückseitige Vertikalholme (27, 28) aufweist und dass die nach außen in Richtung Grundgestell versetzten Profile (21, 22, 23) und das nach innen in Richtung Einbauraum versetzte Profil (24) an dem Grundgestell (20) befestigt sind.

17. Geräteschrank nach einem der vorhergehenden Ansprüche,
**dadurch gekennzeichnet,**
**dass** als Tragarm (8) eine Kabelführungskette (31) vorgesehen ist, welche aus Kettengliedern gebildet und schwenkbar im Bereich des Geräteschrankes (2) sowie am ausziehbaren Gerät (4) angeordnet ist.

18. Geräteschrank nach Anspruch 17,
**dadurch gekennzeichnet,**
**dass** die Kabelführungskette (31) mit einem vorgebbaren, definierten Biegeradius ausgebildet ist.

19. Geräteschrank nach einem der vrohergehenden Ansprüche 1 bis 16,
**dadurch gekennzeichnet,**
**dass** als Tragarm (8) eine Kabelbrücke (40), welche wenigstens einen starren Bereich (41) und wenigstens einen beweglichen Bereich (42) aufweist, vorgesehen ist, wobei der starre Bereich (41) und der bewegliche Bereich (42) zum Einlegen der Kabel (10) von oben U- oder C-förmig ausgebildet sind.

20. Geräteschrank nach Anspruch 19,
**dadurch gekennzeichnet,**
**dass** der bewegliche Bereich (42) als Kopfteil angeordnet und an einem Ende schwenkbar an dem starren Bereich (41) und am gegenüberliegenden Ende am Gerät (4) fixierbar ist.

21. Geräteschrank nach Anspruch 19 oder 20,
**dadurch gekennzeichnet,**
**dass** der bewegliche Bereich (42) aus Gliederelementen (43) besteht, welche derart ausgebildet sind, dass ein Verschwenken in eine Richtung und/oder mit einem definierten Biegeradius vorgebbar ist.

22. Geräteschrank nach Anspruch 21,
**dadurch gekennzeichnet,**
**dass** die Gliederelemente (43) jeweils eine polygonale, insbesondere achteckige Grundfläche (44) und vertikale Schenkel (45, 46) aufweisen, wobei die vertikalen Schenkel (45, 46) parallel zueinander angeordnet und trapezförmig ausgebildet sind sowie eine unterschiedliche Breite aufweisen.

23. Einrichtung zur Kabelführung für eine Geräteschrank nach einem der Ansprüche 1 bis 16,
**dadurch gekennzeichnet,**
**dass** eine Kabelbrücke (40) vorgesehen ist, welche wenigstens einen starren Bereich (41) und wenigstens einen beweglichen Bereich (42) aufweist, und
**dass** der starre Bereich (41) und der bewegliche Bereich (42) zum Einlegen von Kabeln (10) von oben etwa U- oder C-förmig ausgebildet sind.

24. Einrichtung nach Anspruch 23,
**dadurch gekennzeichnet,**
**dass** der bewegliche Bereich (42) Gliederelemente (43) aufweist, welche zueinander und zu dem starren Bereich (41) horizontal verschwenkbar angeordnet sind.

25. Einrichtung nach Anspruch 23 oder 24,
**dadurch gekennzeichnet,**
**dass** der starre Bereich (41) an seinem freien Ende am Geräteschrank (2) und der bewegliche Bereich (42) an seinem freien Ende an einem Gerät (4) fixierbar ist, wobei der starre Bereich (41) über eine vertikale Achse (38) verschwenkbar am Geräteschrank (2), insbesondere an einer Tragplatte (7) einer seitlichen Kabelführung, fixierbar ist.

26. Einrichtung nach einem der Ansprüche 23 bis 25,
**dadurch gekennzeichnet,**
**dass** die Gliederelemente (43) des beweglichen Bereichs (42) derart ausgebildet sind, dass der bewegliche Bereich (42) in eine vorgebbare Richtung und/oder mit einem definierten Biegeradius verschwenkbar ist.

27. Einrichtung nach Anspruch 26,
**dadurch gekennzeichnet,**
**dass** die Gliederelemente (43) wie der starre Bereich (41) jeweils eine Grundfläche (44) und zwei vertikale Schenkel (45, 46) aufweisen, wobei die Grundfläche (44) der Gliederelemente (43) polygonal und die Schenkel (45, 46), welche parallel zueinander angeordnet sind, trapezförmig und mit einer unterschiedlichen Breite ausgebildet sind.

28. Einrichtung nach Anspruch 27,
**dadurch gekennzeichnet,**
**dass** die Grundfläche (44) der Gliederelemente (43) achteckig ausgebildet ist und die Schenkel (46) der Gliederelemente (43), in deren Richtung der bewegliche Bereich (42) verstellbar ist, schmaler als die parallelen Schenkel (45) ausgebildet sind.

29. Einrichtung nach Anspruch 28,
**dadurch gekennzeichnet,**
**dass** die Schenkel (45) zur Blockierung einer Abbiegung in eine vorgebbare Richtung eine entsprechende Breite aufweisen.

30. Einrichtung nach einem der Ansprüche 23 bis 29,
**dadurch gekennzeichnet,**
**dass** der starre Bereich (41) aus Metall besteht und die Gliederelemente (43) des beweglichen Bereichs (42) aus einem Kunststoffmaterial gefertigt sind.

31. Einrichtung nach einem der Ansprüche 23, 26 bis 30,
**dadurch gekennzeichnet,**
**dass** die Kabelbrücke (40) einen starren Bereich (41) und zwei bewegliche Bereiche (42) an gegenüberliegenden Endbereichen des starren Bereichs (41) aufweist.

32. Einrichtung nach einem der Ansprüche 23, 26 bis 30,
**dadurch gekennzeichnet,**
**dass** die Kabelbrücke (40) einen beweglichen Bereich (42) und zwei starre Bereiche (41) aufweist, wobei der bewegliche Bereich (42) zwischen den zwei starren Bereichen (41) angeordnet ist.

## Claims

1. Equipment cabinet having an installation area (3) for electrical and electronic equipment (4) arranged in slide-in module-like manner and in particular servers, and having a region (14) for cabling the equipment (4), the installation area (3) being positioned asymmetrically accompanied by the formation of a lateral free space (5) constructed for cable guidance purposes, in which for the horizontal guidance of cables (10) to the region (14) and to the equipment (4) cable supports (6) are positioned horizontally in accordance with the superimposed equipment (4),
**characterized in that**
as cable supports (6) support arms (8) are pivotably located in the lateral free space (5).

2. Equipment cabinet according to claim 1,
**characterized in that**
the support arms (8) have a length corresponding roughly to half the displacement path of the equipment (4) arranged in slide-in module-like manner.

3. Equipment cabinet according to claims 1 or 2,
**characterized in that**
as cable supports (6) support plates (7) are placed in the lateral free space (5) and in each case one support arm (8) is fixed to a support plate (7).

4. Equipment cabinet according to claim 3,
**characterized in that**
the support plates (7) have guidance and/or reversing elements (9) for the cables (10).

5. Equipment cabinet according to claim 4,
**characterized in that**
joints and guide pulleys are provided as guidance and reversing elements (9).

6. Equipment cabinet according to one of the claims 3 to 5,
**characterized in that**
the support plates (7) are provided with a matrix of holes (11) for the adjustable reception of the guidance and reversing elements (9) and/or support arms (8).

7. Equipment cabinet according to one of the preceding claims,
**characterized in that**
the lateral free space (5) in a front area is constructed as an additional installation area (12) for equipment (13) with corresponding dimensions.

8. Equipment cabinet according to claim 7,
**characterized in that**
in the case of a cabinet width of 700 mm and cabinet height of 48 height units, as well as an installation area (3) corresponding to the 19" system, the laterally and frontally constructed, additional installation area (12) is provided for the reception of three vertically positioned 19" modules (13) having in each case three height units and a corresponding depth.

9. Equipment cabinet according to one of the preceding claims,
**characterized in that**
the cable supports (6) are at least located in a central zone (15) of the lateral free space (5) and are fixed to at least one front vertical bracket (16) and a rear vertical profile (23) displaced outwards towards the base frame.

10. Equipment cabinet according to claim 9,
**characterized in that**
the front vertical bracket (16) is constructed for fixing module rails (18), which are placed in the additional installation area (12) for receiving the 19" modules (13).

11. Equipment cabinet according to claim 9 or 10,
**characterized in that**
rear holding devices (17) are provided for fixing extraction elements (19) for the equipment (4) of the installation area (3) and are fixed to the rear vertical profile (23) displaced outwards towards the base frame.

12. Equipment cabinet according to claim 11,
**characterized in that**
the rear holding devices (17) are constructed as cross-sectionally U or L-shaped angles.

13. Equipment cabinet according to one of the claims 9 to 12,
**characterized in that**
the front vertical bracket (16) is constructed for detachable and/or toolless reception of the support plates (7).

14. Equipment cabinet according to one of the preceding claims,
**characterized in that**
the lateral free space (5) for cable guidance is positioned to the right or left alongside the installation area (3).

15. Equipment cabinet according to one of the preceding claims,
**characterized in that**
for the asymmetrical arrangement of the installation area (3) a front profile (21) and two rear profiles (22, 23) are displaced outwards towards the base frame and the second front profile (24) inwards in the direction of the installation area (3) for forming the lateral free space (5).

16. Equipment cabinet according to claim 15,
**characterized in that**
the base frame (20) has a rectangular or X-shaped upper and lower frame and front vertical struts (25, 26) and rear vertical struts (27, 28) and that the profiles (21, 22, 23) displaced outwards towards the base frame and the profile (24) displaced inwards towards the installation area are fixed to the base frame (20).

17. Equipment cabinet according to one of the preceding claims,
**characterized in that**
the support arm (8) is constituted by a cable guidance chain (31) formed from chain links and located pivotably in the vicinity of the equipment cabinet (2) and at the extractable equipment (4).

18. Equipment cabinet according to claim 17,
**characterized in that**
the cable guidance chain (31) is constructed with a predeterminable, defined bending radius.

19. Equipment cabinet according to one of the preceding claims 1 to 16,
**characterized in that**
as the support arm (8) is provided a cable bridge (40), which has at least one rigid area (41) and at least one movable area (42), the rigid area (41) and movable area (42) being given a U or C-shaped construction for the insertion of cables (10) from above.

20. Equipment cabinet according to claim 19,
**characterized in that**
the movable area (42) is provided as a top part and at one end can be pivotably fixed to the rigid area (41) and at the opposite end to the equipment (4).

21. Equipment cabinet according to claim 19 or 20,
**characterized in that**
the movable area (42) comprises link elements (43) constructed in such a way that it is possible to predetermine a pivoting in one direction and/or with a defined bending radius.

22. Equipment cabinet according to claim 21,
**characterized in that**
the link elements (43) in each case have a polygonal, particularly octagonal base surface (44) and vertical sides (45, 46), which are parallel to one another and trapezoidally constructed, whilst also having a different width.

23. Device for cable guidance for an equipment cabinet according to one of the claims 1 to 16,
**characterized in that**
a cable bridge (40) is provided having at least one rigid area (41) and at least one movable area (42) and that the rigid area (41) and movable area (42) are constructed roughly U or C-shaped for inserting cables (10) from above.

24. Device according to claim 23,
**characterized in that**
the movable area (42) has link elements (43), which are horizontally pivotably positioned relative to one another and to the rigid area (41).

25. Device according to claim 23 or 24,
**characterized in that**
the rigid area (41) by its free end can be fixed to the equipment cabinet (2) and the movable area (42) by its free end to an equipment (4), the rigid area (41) being fixable by means of a vertical shaft (38) to the equipment cabinet (2), particularly to a support plate (7) of a lateral cable guide.

26. Device according to one of the claims 23 to 25,
**characterized in that**
the link elements (43) of the movable area (42) are constructed in such a way that said movable area (42) is pivotable in a predeterminable direction and/or with a defined bending radius.

27. Device according to claim 26,
**characterized in that**
the link elements (43) and the rigid area (41) in each case have a base surface (44) and two vertical sides (45, 46), the base surface (44) of the link elements (43) being polygonal and the sides (45, 46), which are parallel to one another, are trapezoidal and have a different width.

28. Device according to claim 27,
**characterized in that**
the base surface (44) of the link elements (43) is octagonal and the sides (46) of the link elements (43), in whose direction the movable area (42) is adjustable, are narrower than the parallel sides (45).

29. Device according to claim 28,
**characterized in that**,
for blocking a bending in a predeterminable direction, the sides (45) have a corresponding width.

30. Device according to one of the claims 23 to 29,
**characterized in that**
the rigid area (41) is made from metal and the link elements (43) of the movable area (42) are made from a plastics material.

31. Device according to one of the claims 23, 26 to 30,
**characterized in that**
the cable bridge (40) has a rigid area (41) and two movable areas (42) in facing end regions of the rigid area (41).

32. Device according to one of the claims, 23, 26 to 30,
**characterized in that**
the cable bridge (40) has a movable area (42) and two rigid areas (41), the movable area (42) being positioned between the two rigid areas (41).

## Revendications

1. Armoire pour appareillage qui comprend un espace de montage (3) pour des appareils électriques et électroniques (4) insérables par coulissement, notamment des serveurs, une zone (14) pour le câblage des appareils (4), l'espace de montage (3) étant asymétrique avec formation latéralement d'un espace libre (5) pour le passage des câbles, dans lequel pour guider horizontalement ces câbles (10) en direction de la zone (14) et des appareils (4), sont disposés horizontalement des supports de câble (6) en correspondance avec les appareils (4) montés superposés, cette armoire étant
**caractérisée en ce que**
les supports de câble (6) sont des bras porteurs (8) qui peuvent basculer dans l'espace libre latéral (5).

2. Armoire pour appareillage selon la revendication 1,
**caractérisée en ce que**
les bras porteurs (8) ont une longueur qui correspond à peu près à la moitié de la course de coulissement des appareils insérables (4).

3. Armoire pour appareillage selon la revendication 1 ou 2,
**caractérisée en ce que**
les supports de câble (6) sont des plaques porteuses (7) qui sont disposées dans l'espace libre (5), avec chaque fois un bras porteur (8) fixé à une plaque porteuse (7).

4. Armoire pour appareillage selon la revendication 3,
**caractérisée en ce que**
les plaques porteuses (7) présentent des éléments de guidage et/ou de déviation (9) destinés aux câbles (10).

5. Armoire pour appareillage selon la revendication 4,
**caractérisée en ce que**
les éléments de guidage et de déviation (9) sont constitués par des articulations et des rouleaux de déviation.

6. Armoire pour appareillage selon une des revendications 3 à 5,
**caractérisée en ce que**
les plaques porteuses (7) sont équipées d'une grille à trous (11) pour accueillir de manière réglable les éléments de guidage et de déviation (9) et/ou les bras porteurs (8).

7. Armoire pour appareillage selon une des revendications précédentes,
**caractérisée en ce que**
l'espace libre latéral (5) est réalisé dans une zone frontale en tant qu'espace de montage supplémentaire (12) pour des appareils (13) avec des dimensions correspondantes.

8. Armoire pour appareillage selon la revendication 7,
**caractérisée en ce que**
dans une armoire ayant une largeur de 700 mm et une hauteur de 48 unités de hauteur, avec un espace de montage (3) correspondant au système à 19", l'espace de montage supplémentaire (12) disposé latéralement et frontalement est prévu pour accueillir trois dispositifs enfichables de 19" disposés verticalement et ayant chacun une hauteur de trois unités et la profondeur correspondante.

9. Armoire pour appareillage selon une des revendications précédentes,
**caractérisée en ce que**
les supports de câble (6) sont disposés dans une zone médiane (15) de l'espace latéral libre (5) et ils sont fixés sur au moins un appui vertical frontal (16) et sur un profilé vertical (23) disposé vers l'arrière avec décalage vers l'extérieur en direction du châssis de base.

10. Armoire pour appareillage selon la revendication 9,
**caractérisée en ce que**
l'appui vertical frontal (16) est prévu pour la fixation de rails de coulissement (18) disposés dans l'espace de montage supplémentaire (12) servant à accueillir les dispositifs insérables de 19" (13).

11. Armoire pour appareillage selon la revendication 9 ou 10,
**caractérisée en ce que**
des dispositifs arrière de maintien (17) sont prévus pour la fixation d'éléments d'extraction (19) destinés aux appareils (4) de l'espace de montage (3), et ils sont fixés sur le profilé vertical (23) situé en arrière et décalé en direction du châssis de base.

12. Armoire pour appareillage selon la revendication 11,
**caractérisée en ce que**
les dispositifs arrière de maintien (17) sont des cornières à section en U ou en L.

13. Armoire pour appareillage selon une des revendications 9 à 12,
**caractérisée en ce que**
l'appui vertical frontal (16) est configuré pour accueillir les plaques porteuses (7) de manière séparable et/ou sans outil.

14. Armoire pour appareillage selon une des revendications précédentes,
**caractérisée en ce que**
l'espace latéral libre (5) pour le passage des câbles, est disposé près de l'espace de montage (3), à droite ou à gauche.

15. Armoire pour appareillage selon une des revendications précédentes,
**caractérisée en ce que**
pour réaliser le montage asymétrique de l'espace de montage (3), un profilé frontal (21) et les deux profilés arrière (22, 23) sont décalés vers l'extérieur en direction du châssis de base, tandis que pour former l'espace latéral libre (5) le second profilé frontal (24) est décalé vers l'intérieur en direction de l'espace de montage (3).

16. Armoire pour appareillage selon la revendication 15,
**caractérisée en ce que** le
châssis de base (20) présente un cadre supérieur et inférieur en forme de rectangle ou d'X, ainsi que des montants verticaux frontaux (25, 26) et des montants verticaux arrière (27, 28), et les profilés (21, 22, 23) décalés vers l'extérieur en direction du châssis de base (20) ainsi que le profilé (24) décalé vers l'intérieur en direction de l'espace d'accueil (3) sont fixés sur ce châssis (20).

17. Armoire pour appareillage selon une des revendications précédentes,
**caractérisée en ce que**
comme bras porteur (8) une chaîne de guidage de câble (31) est composée d'organes de chaîne et peut basculer dans la zone de l'armoire pour appareillage (2) en étant disposée sur l'appareil extractible (4).

18. Armoire pour appareillage selon la revendication 17,
**caractérisée en ce que**
la chaîne de guidage de câble (31) présente un rayon de flexion défini qui peut être donné à l'avance.

19. Armoire pour appareillage selon une des revendications 1 à 16,
**caractérisée en ce que**
comme bras porteur (8) est prévu un pont de câble (40) présentant au moins une partie rigide (41) et au moins une partie mobile (42), ces deux parties (41, 42) ayant pour installer des câbles d'en haut, une section en forme d'un U ou d'un C.

20. Armoire pour appareillage selon la revendication 19,
**caractérisée en ce que**
la partie mobile (42) est la partie de tête, elle peut basculer par une extrémité sur la partie rigide (41) et être fixée par l'autre extrémité sur l'appareil (4).

21. Armoire pour appareillage selon la revendication 19 ou 20,
**caractérisée en ce que**
la partie mobile (42) est constituée d'éléments d'organe (43) constitués de manière qu'un basculement dans une direction et/ou avec un rayon de flexion défini peut être donné à l'avance.

22. Armoire pour appareillage selon la revendication 21,
**caractérisée en ce que**
les éléments d'organe (43) présentent chacun une surface de base (44) polygonale, notamment octogonale, ainsi que des branches verticales (45, 46) parallèles entre elles, qui ont une forme trapézoïdale ainsi que des largeurs différentes.

23. Dispositif de guidage de câble pour une armoire d'appareillage selon une des revendications 1 à 16,
**caractérisé en ce qu'**
il est prévu un pont de câble (40) présentant au moins une partie rigide (41) et au moins une partie mobile (42), et pour installer des câbles d'en haut, ces deux parties (41, 42) ont une section en forme d'un U ou d'un C.

24. Dispositif selon la revendication 23,
**caractérisé en ce que**
la partie mobile (42) présente des éléments d'organe (43) pouvant basculer horizontalement les uns par rapport aux autres et aussi par rapport à la partie rigide (41).

25. Dispositif selon la revendication 23 ou 24,
**caractérisé en ce que**
la partie rigide (41) est à son extrémité libre fixée à l'armoire d'appareillage (2) tandis que la partie mobile (42) est à son extrémité libre fixée à un appareil (4), et la partie rigide (41) qui peut basculer sur l'armoire d'appareillage (2) autour d'un axe vertical (38) peut notamment être fixée sur une plaque porteuse (7) d'un guidage latéral de câble.

26. Dispositif selon une des revendications 23 à 25,
**caractérisé en ce que**
les éléments d'organe (43) de la partie mobile (42) sont constitués de manière que la partie mobile (42) peut basculer selon une direction prédéfinissable et/ou avec un rayon de flexion défini.

27. Dispositif selon la revendication 26,
**caractérisé en ce que**
les éléments d'organe (43) ainsi que la partie rigide (41) présentent chacun une surface de base (44) et deux branches verticales (45, 46), cette surface de base (44) étant polygonale tandis que les branches (45, 46) qui sont parallèles entre elles, ont la forme d'un trapèze mais des largeurs différentes.

28. Dispositif selon la revendication 27,
**caractérisé en ce que**
la surface de base (44) des éléments d'organe (43) est octogonale et les branches (46) des éléments d'organe (43) en direction desquelles peut se déplacer la partie mobile (42), sont plus étroites que les branches parallèles (45).

29. Dispositif selon la revendication 28,
**caractérisé en ce que**
les branches (45), pour bloquer une flexion dans une direction prédéfinissable, présentent une largeur correspondante.

30. Dispositif selon une des revendications 23 à 29,
**caractérisé en ce que**
la partie rigide (41) est en métal et les éléments d'organe (43) de la partie mobile (42) sont à base de matière plastique.

31. Dispositif selon une des revendications 23, 26 à 30,
**caractérisé en ce que**
le pont de câble (40) présente une partie rigide (41) et deux parties mobiles (42) aux extrémités opposées de la partie rigide (41).

32. Dispositif selon une des revendications 23, 26 à 30,
**caractérisé en ce que**
le pont de câble (40) présente une partie mobile (42) et deux parties rigides (41) entre lesquelles se trouve la partie mobile (42).
